# EUROPEAN PATENT APPLICATION

(11) **EP 2 672 529 A1**
(43) Date of publication of application: **11.12.2013**
(21) Application number: 12170689.9
(22) Date of filing: 04.06.2012
(51) Int. Cl.: H01L 31/18, H01L 31/073

(54) **Method for production of a photovoltaic device in substrate configuration**

(71) Applicant: EMPA, 8600 Dübendorf (CH)
(72) Inventor: Kranz, Lukas, 8050 Zürich (CH); Gretener, Christina, 8603 Schwerzenbach (CH); Perrenoud, Julian, 8032 Zürich (CH); Buecheler, Stephan, 79875 Dachsberg (DE); Tiwari, Ayodhya N., 8051 Zürich (CH)
(74) Representative: Schneider Feldmann AG Patent- und Markenanwälte

(57) **Abstract**

Conventionally, CdTe solar cells are grown in superstrate configuration where the light enters the photovoltaic device through a transparent substrate. Still, efficiencies of CdTe solar cells grown in substrate configuration have so far been considerably lower than those grown in superstrate configuration. This invention discloses a photovoltaic device (0) in substrate configuration and a process of making thereof with which efficiencies approaching those of superstrate devices can be reproducibly achieved. Furthermore, long term stability is expected to be better than in state of the art devices. This method is advantageous because the growth in substrate configuration offers several advantages like the growth on metal foils and a more precise control of the junction.

## Description

### TECHNICAL FIELD

The present invention describes a method for production of a photovoltaic device in substrate configuration, comprising a p-semiconducting absorber layer which is deposited on a back contact coated substrate, and a window layer. Furthermore it describes a multilayer thin film solar cell with a p-type semiconducting absorber layer and a n-type semiconducting window layer grown on a back contact and a substrate in substrate configuration.

### STATE OF THE ART

Increasing oil prices are emphasizing the need of low cost solar electricity. While currently most photovoltaic electricity is produced from crystalline silicon, thin film technologies like Cu(In,Ga)Se2, amorphous Si, or CdTe are increasing their market share. CdTe comprising photovoltaic devices have proven to be one of the cheapest photovoltaic technologies due to the simplicity of the production process. The company First Solar is producing more than 1 GWp per year at prices well below 1 $/Wp.

Further price reduction can be expected by producing flexible CdTe solar cells by roll-to-roll production using CdTe solar cells in substrate configuration.

As disclosed in Singh et al., "Thin film CdTe-CdS herterojunction solar cells on lightweight metal substrates", Solar Energy Materials & Solar Cells 59 (1999), a photovoltaic device in substrate configuration, based on a thin metal foil as substrate was achieved. By introducing a conductive interlayer between substrate and CdTe absorber layer, before depositing the CdTe absorber layer onto the substrate, the electrical properties could be improved. The electrical contact between the substrate and the absorber layer could therewith be improved. The reachable efficiency was still not satisfying. Due to the fact that the absorber-window junction is crucial to the cell performance, Singh et al. describe the deposition of up to two CdS layers followed by annealing steps to reach optimal formation of CdTe and CdS in the region of the junction.

All the produced CdTe solar cells in substrate configuration so far exhibit lower efficiencies compared to their superstrate counterpart. Up to 17.3% efficiency has been achieved in superstrate configuration (15.6% in our lab), while for example Gessert et al. ["Comparison of CdS/CdTe superstate and substrate devices fabricated with a ZnTe:Cu contact interface", Proceeding of IEEE PV Specialists Conference 2010, p335] report efficiencies well below 10% for CdTe solar cells in substrate configuration. Due to the inferior reachable efficiency of the photovoltaic devices in substrate configuration, the document of Gessert et al. could be understood as an advice against the substrate configuration, which seems to be more problematic to be controlled.

On the other hand the conventional superstrate configuration, where light has to pass through the substrate in the finished device, prohibits the use of flexible metal foil substrates and leads to considerable absorption losses when cells are grown on flexible polyimide foil.

In state of the art CdTe solar cells in substrate configuration, Cu is added at the back contact e.g. in the form of CuTeₓ or Cu doped ZnTe with equivalent layer thicknesses of at least several nanometers. Long term stability of CdTe solar cells is strongly affected by the amount of Cu used in the back contact as excessive Cu diffusion towards the junction can deteriorate cell performance. On the one hand, enough Cu has to be added to achieve highest efficiencies, on the other hand, addition of Cu leads to inferior long term stability. Therefore, in state of the art CdTe solar cells it is difficult to combine highest performance with long term stability.

### DESCRIPTION OF THE INVENTION

The object of the present invention is to create a method for production of a photovoltaic device in substrate configuration, which is low-priced, can be carried out reproducibly and leads to photovoltaic devices with high efficiencies, e.g. exceeding 13%, and fill factors above 70%. Flexible CdTe absorber photovoltaic devices on cheap metal or plastic foil as substrate with efficiencies approaching those on rigid glass can be achieved.

In state of the art CdTe solar cells in substrate configuration, copper was added on the back contact in high amounts, improving the ohmic contact between back contact and CdTe absorber layer.

We have found that the addition of much smaller amounts of conductive material at a later processing step considerably enhances performance of the devices and reproducibility of the process.

### BRIEF DESCRIPTION OF THE DRAWINGS

Preferred production methods and the resulting photovoltaic devices are described below in conjunction with the attached drawings.
- Figure 1: shows a schematic sectional view of one embodiment of a photovoltaic device in substrate configuration.
- Figure 2a: shows a schematic sectional view of a basic method of stepwise production, while
- Figure 2b: shows a schematic view of step b', where the metal component is deposited at first and
- Figure 2c: shows a schematic view of a varied step b" where the n-type semiconducting material is deposited at first.
- Figure 3a: shows a schematic sectional view of another embodiment of a production method, depositing a second n-type semiconducting material layer, after a further treatment step.
- Figure 3b: shows a TEM image of a doubled window layer, after deposition of a second n-type semiconductor layer, comprising one large grained pretreated CdS layer and one nano-grained CdS resulting of the second deposition step.
- Figure 3c: shows a diagram of the depth dependant metal component (in this case Cu) distribution in different layers of the photovoltaic device after production according figure 3a), while
- Figure 3d: is showing the copper concentration in the doubled CdS window layer magnified, comprising large grained CdS and nano-grained CdS and the difference in copper concentration.
- Figure 3e: shows a XRD pattern, showing that the first window layer comprising as deposited CdS grows in a phase which differs from the phase of the optimized double-CdS layer.
- Figure 4: shows a I/V diagram where a photovoltaic device produced with the method according to figure 2a is compared with a photovoltaic device with a double CdS layer produced with the method according to figure 3a.

### DESCRIPTION

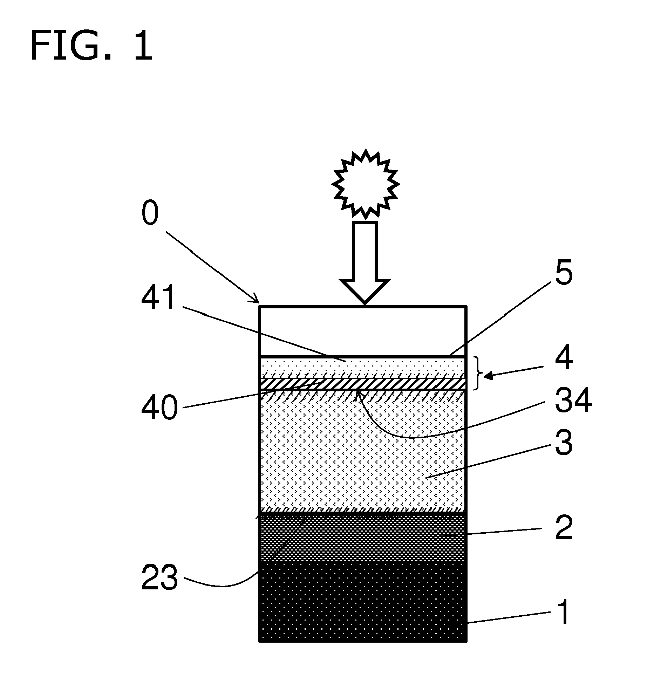

A photovoltaic device 0 is shown in figure 1 in a schematic cross section. The photovoltaic device 0 is a multilayer thin film device consisting of several semiconductor and metal layers. Figure 1 shows the photovoltaic device 0 in the form of a CdTe/CdS solar cell in substrate configuration, where the reference numerals are roughly characterizing the order of deposition.

On a substrate 1 a conducting back contact 2 is deposited. Onto the back contact 2 an absorber layer 3, here in the form of CdTe as p-type semiconducting material is added. Between the back contact 2 and the absorber layer 3 a back contact-absorber interface 23 is formed. Placed onto the absorber layer 3 on the side facing away from the back contact 2 is a window layer 4, comprising n-type semiconducting material 41 and a metal component 40. The junction between absorber layer 3 and window layer 4 forms the area of the absorber-window-junction or pn-junction 34. On top of the window layer 4 a transparent contact layer 5 in form of at least a transparent oxide layer is deposited, through which light enters the finished photovoltaic device 0. A metallic grid can optionally be deposited on top of the photovoltaic device 0 to improve the transparent contact resistance. All these layers are subsequently deposited onto each previous layer. Each layer can cover all or a part of the underlying layer.

Because light in this configuration does not have to pass through the substrate 1, opaque substrates 1 like metal foils can be used. This would enable roll-to roll production, which can considerably reduce manufacturing cost of the devices 0. It is common practice to use a multilayer back contact comprising at least a conductive layer and at least a buffer layer, which is not depicted here. Furthermore, a barrier layer can be introduced between the substrate and the conducting back contact, which is not depicted here.

The substrate 1 can comprise glass, polymer or metal foil. The back contact can comprise metals like Mo, W, Al, Cr, Ni, Ti, Ag, Au or Pt, oxides like ZnO:Al, tin doped indium oxide or fluorine doped tin oxide, nitrides like MoN or TiN or combinations thereof.

The p-type semiconductor absorber can be made of CdTe or a mixture comprising CdTe. The n-type semiconducting material of the window layer can be made of CdS or a mixture comprising CdS.

Each underlying layer has to withstand the temperatures during the subsequent depositions. This leads to different diffusion of impurities or interdiffusion of different layers as compared to the conventional superstrate configuration. Therefore the new processes had to be invented specially for the growth in substrate configuration.

In the following a method for production of a photovoltaic device 0 by means of an absorber layer 3 comprising CdTe as p-type semiconductor, a metal component 40 consisting of copper and a window layer 4 comprising CdS as n-type semiconducting material 41 is described.

With treatment or pretreatment a conditioning of the topmost layers in the form of an annealing in the presence of chlorine containing species, for example CdCl₂ or Freon® gas, preferably CdCl₂ at temperatures between 350°C and 500°C for time periods of minutes up to hours is meant. The treatment atmosphere can contain oxygen.

Annealing means the annealing of the topmost layers with at least 180°C for time periods of minutes up to hours. The annealing atmosphere can contain oxygen.

A so called diffusion treatment can be performed by the explained annealing or the explained treatment. The diffusion treatment is a tempering process which also leads to diffusion of deposited metal atoms into different layers of the photovoltaic device 0.

For deposition of a polycrystalline thin-film of CdTe as absorber layer 3 the person skilled in the art uses for example close spaced sublimation, electrodeposition, sputtering, high vacuum thermal evaporation methods, vapor transport deposition, metal organic vapor deposition, spray deposition, screen printing, nanoparticle based approach or other chemical methods. The preferred deposition method is high vacuum evaporation at a substrate temperature of about 300 °C.

Starting with the already deposited CdTe layer 3 typically with a thickness of a few micrometers, preferred 5µm, a first treatment a) step of the surface of the absorber layer 3 is carried out. The first treatment a) comprises an annealing of the absorber layer 3 in the presence of CdCl₂ at temperatures of higher than 350°C for minutes to hours. The atmosphere can contain oxygen. Preferred is a deposition of 400 nm of CdCl₂ by high vacuum evaporation, followed by an anneal for 25 minutes at 430°C in an atmosphere containing 40% of oxygen

In the following a window layer 4, comprising a metal component 40 and n-type semiconducting material 41 will be deposited together onto the pretreated surface of the absorber layer 3 in a deposition step b).

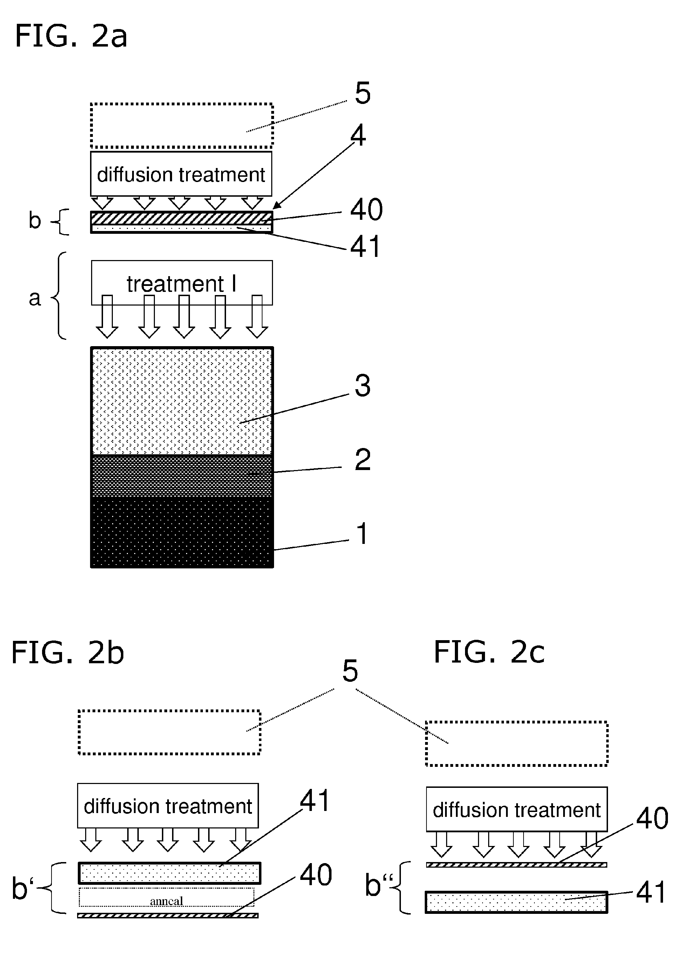

The n-type semiconducting material 41 (here CdS) and the metal component 40 can be deposited either simultaneous as shown in figure 2a) or timely staggered in different chronological order as depicted in figure 2b) (step b') and 2c) (step b"). The amount of the metal component 40 lies in all embodiments in a range equivalent to a layer of a thickness of less than 0.5 nm, preferred between 0.05-0.15 nm. Dependant of the deposition method the metal component 40 is deposited for example by physical vapour deposition, by application of a metal component containing solution or by chemical methods in a separate step or the metal is mixed up with CdS material or it can be included in the chemical bath for deposition of CdS.

The deposition of CdS with or without metal atoms is for example possible by sputtering, vacuum evaporation, closed space sublimation, chemical bath deposition, spray pyrolysis, electrodeposition or other chemical methods. We preferred chemical bath deposition at 70 °C. The thickness of the CdS window layer 4 can for example be between 50 and 200 nm. The achieved thickness of the window layer 3 was about 100 nm. Accordingly the relative amount of the introduced metal component 40 can be in the range of 1/1000 relative to the window layer 3 thickness.

After the deposition step b) a diffusion treatment in form of an annealing or treatment as described above is following, leading to the diffusion of copper atoms through the window layer 4, the absorber layer 3 to the back contact 2. The diffusion treatment is carried out at at least 180 °C for time periods of minutes.

We have found, that the deposition of small amounts of the conducting metal component 40, for example elements of group 11 or group IB of the periodic table of elements comprising copper, gold or silver directly or in combination with the deposition of CdS onto the surface of the pretreated absorber layer 3 on the side facing away from the back contact 2 enhances the performance of the photovoltaic device 0 and reproducibility of the process.

Beside the simultaneous deposition according to step b) the deposition of the metal component 40 and the n-type semiconductor 41 can be carried out timely staggered according to Figures 2b) and 2c).

According to step b') in Figure 2b) the metal component 40 is deposited with an amount equivalent to a layer thickness of less than 0.5 nm directly onto the pretreated absorber layer 3. For example it can be between 0.05 and 0.15 nm. The metal component deposition is followed by deposition of a CdS layer 41 comprising an amount of CdS material 41 for example by chemical bath deposition. After this timely staggered deposition of metal atoms and the n-type semiconducting material 41 the diffusion treatment is carried out, for example by a further treatment step at temperatures of 400 °C. The atmosphere can contain oxygen. The copper atoms are diffusing through the CdS layer 4, CdTe layer 3 and to the back contact 2 due to the diffusion process. Optional an annealing step can be carried out after copper deposition and before CdS deposition, as indicated in figure 2b. For example, the annealing step can be carried out at around 400°C in an atmosphere that can contain oxygen.

According to step b") in Figure 2c) the chronological order of deposition is changed and at first the CdS material 41 is deposited directly onto the pretreated surface of the CdTe layer 3. After the CdS deposition the deposition of the metal component 40 with an equivalent layer thickness of less than 0.5 nm is carried out. The metal atoms of the metal component 40 are later diffusing in the semiconductor layers due to further diffusion treatment in form of thermal conditioning. During processing, Cu diffuses and in the finished device it is distributed in several layers including CdS 4, CdTe 3 and at the back contact-absorber interface 23 of the solar cell.

For deposition of CdS we used CBD (chemical bath deposition) by which CdS is deposited in the form of nano crystals with sizes less than 30 nm. Therewith CdS layer 4 comprising nano-grained CdS structures can be achieved. Because of the use of nano crystals of CdS with crystal sizes less than 30 nm, deposited CdS layer 41 is forming a nano-grained structure. If further thermal diffusion treatments are carried out a large grained CdS layer can be formed.

After deposition of the metal component 40, the metal (in this case copper) diffuses into every layer due to diffusion treatments, which was proved by SIMS measurements, which showed higher Cu-signal levels for every layer as compared to Cu free samples. In the near of the back contact-absorber junction 23 and the window layer 4 the highest Cu-signal levels could be measured due to the highest copper concentrations. We have found, that the addition of small amounts of copper (e.g. 10^-7g/cm^2) after recrystallization of the CdTe layer 3 considerably enhances performance of the devices and reproducibility of the process.

We identified an influence of copper in the CdTe absorber layer 3 as it increases acceptor density and reduces space charge region. This can increase the open circuit voltage of the device and reduce a hole blocking barrier at the back contact. Furthermore, it was found that appropriate amounts of Cu in CdS window layer 4 also have a beneficial effect. For example, Cu could enhance photoconductivity of the window layer 4. A similar effect could be achieved by other impurities like oxygen, hydrogen or combinations thereof.

As much less Cu is used the newly developed process is expected to have a beneficial effect on the long-term stability of the photovoltaic device 0, as stability issues were commonly associated with diffusion of Cu and accumulation of excessive Cu in CdS.

We have tested several positions of Cu, amounts of Cu and different annealing or diffusion treatment temperatures. As specific example, good efficiencies can be obtained by adding about 0.8 Angstrom of Cu by high vacuum evaporation on top of CdTe 3 after the first treatment at around 430 °C in 40% of oxygen in the presence of 400 nm of CdCl₂ and enhancing diffusion of Cu into CdTe with an annealing at around 400°C in an atmosphere containing 40% of oxygen, acting as diffusion treatment before the deposition of CdS. As the layer of the photovoltaic device 0 are again annealed after deposition of the next layer (41, CdS), Cu also diffuses into this n-type semiconducting layer 41.

Subsequently, 100 nm of CdS is deposited, followed by a treatment, which leads to recrystallisation and grain growth of the CdS and diffusion of Cu into the CdS layer. Preferrably the treatment after deposition of CdS is performed in the presence of 100 nm of CdCl₂ in an ambient containing 50% of oxygen at around 400°C. Afterwards another CdS (e.g. 100 nm) can be deposited as described below.

All produced photovoltaic devices 0 showed a depth dependant distribution with non-zero metal concentration at the back contact 2, absorber layer 3 and window layer 4, measured by secondary ion mass spectroscopy (SIMS). The metal component concentration in the window layer 4 was higher than in most parts (>90%) of the absorber layer 3. For example, the concentration of the metal component in the window layer 4 can be at least 10 times higher than in the absorber layer 3. For example, the concentration of the metal component can be greater than 10¹⁸ cm⁻³ in the window layer 4 and less than 10¹⁸ cm⁻³ in most parts of the absorber layer. Interpretation of SIMS measurements is difficult due to matrix effects. Still we could identify two maximum metal concentrations to be located, one in the n-type semiconducting window layer 4 and one at the interface 23 between absorber layer 3 and the back contact 2. These copper accumulations could be produced with diffusion treatment steps. Such thin film photovoltaic devices 0 with substrate configuration are reaching the wanted efficiencies. Cu distributes in the semiconductor layers and can lead to concentrations of greater than 10¹⁸ cm⁻³ in CdS 4 and close to the back contact interface 23 and less than 10¹⁸ cm⁻³ in CdTe layer 3. For example, the concentration in the CdS 4 and close to the back contact interface 23 was at least one order of magnitude higher than in most parts (>90%) of the absorber layer 3. For example, the concentration in the CdS 4 was between 2*10¹⁸ and 1*10²⁰ cm⁻³, in most of the CdTe 3 (>90%) it can be between 1*10¹⁶ to 9*10¹⁷ cm⁻³ and close to the back contact interface 23 it was between 2*10¹⁸ and 1*10²⁰ cm⁻³. More specifically, the concentration in the CdS 4 was around 7*10¹⁸ cm⁻³ and in most of the CdTe 3 (>90%) around 1*10¹⁷ cm⁻³ and at the back contact interface 23 around 1*10¹⁹ cm⁻³.

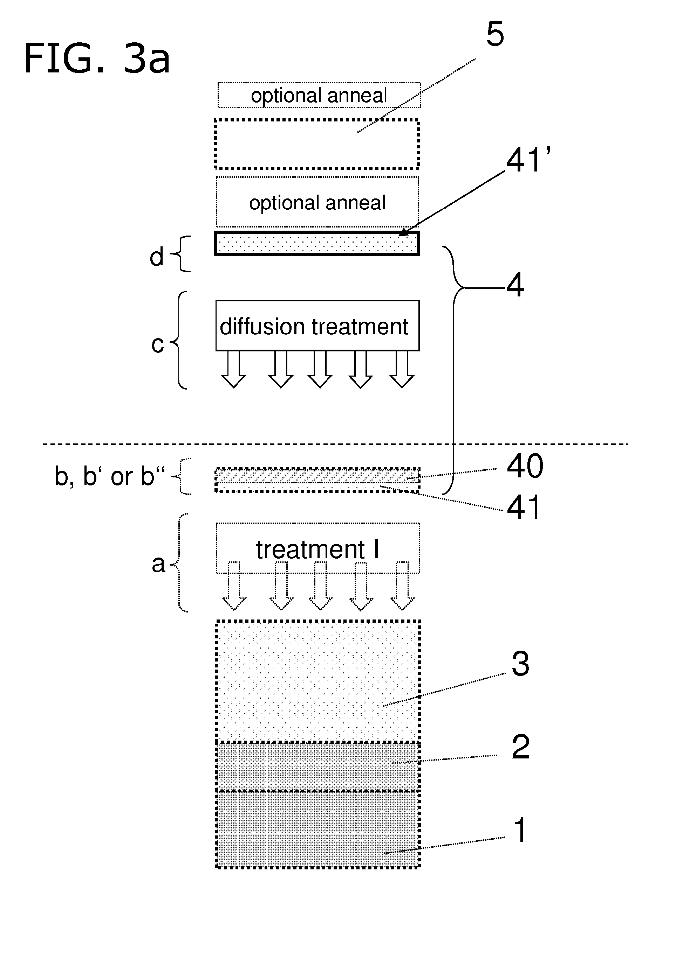

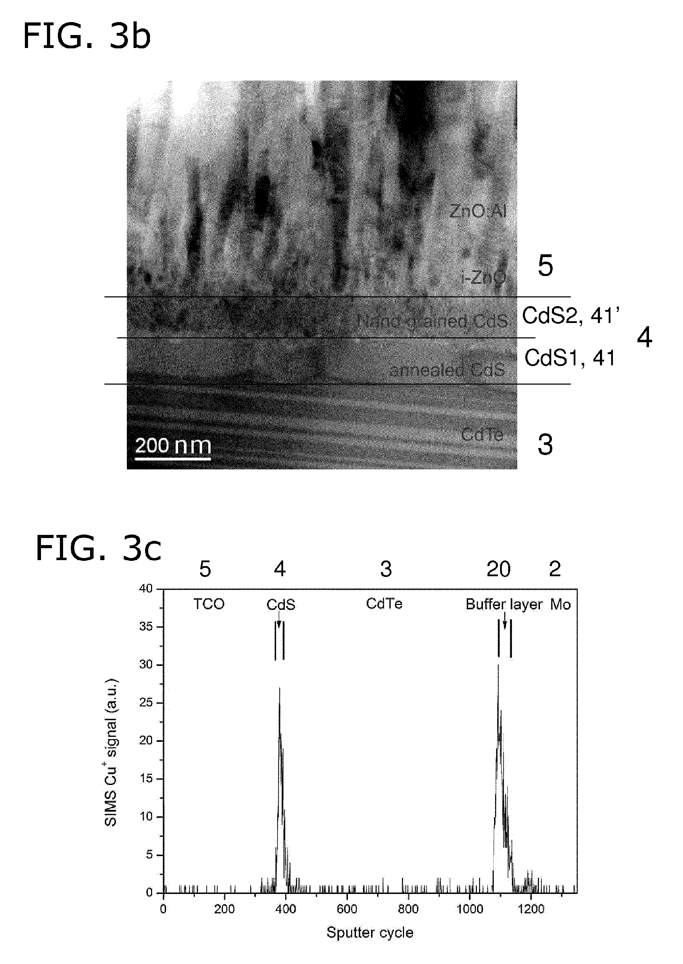

In lightly modified embodiment of the production method the diffusion treatment has been changed. The method is stepwise shown in figure 3a, while the results of an exemplary analysis are shown in figures 3b to 3e. The achievable multi layer thin film photovoltaic device 0 possesses a window layer with one CdS1, 41 and another CdS2, 41' layer (double layered CdS layer 4) with a copper depth distribution as described above.

The produced photovoltaic device 0 is based on a buffer layer 20, which is deposited as part of the back contact 2. The buffer layer 20 can for example comprise MoOₓ, SbₓTe_{y}, BiₓTe, Sb, ZnTe, CuTeₓ, Te, Cu doped CdTe or combinations thereof. Here, the metallic part of the back contact 2 is Mo and the buffer layer 20 is a double layer of MoOₓ and Te. Preferred thicknesses of the metal back contact 2 and the buffer layer 20 are 0.5-1 µm and 50-300 nm, respectively.

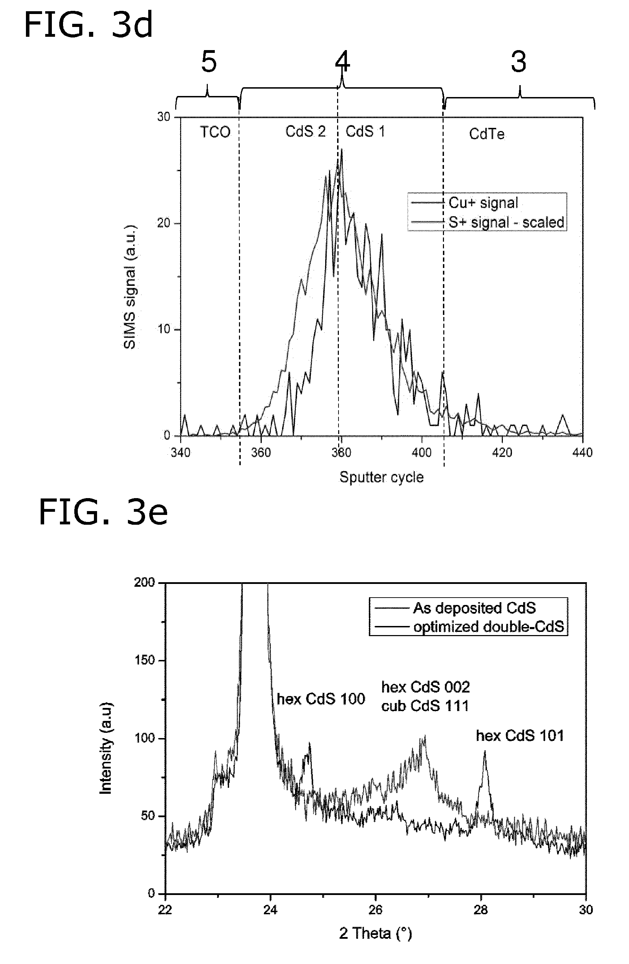

After the deposition of the CdTe on the buffer layer 20 and the first treatment according to step a) the deposition of metal component 40 and n-type semiconducting material 41 according to step b), b') or b") is carried out. A diffusion treatment in form of a second treatment c) is following using the described treatment parameters. Due to the diffusion treatment metal atoms diffuse in the layers 2, 20, 3, 4 and the grain size of CdS1 41 is enlarged as can be seen in figure 3b. It leads to recrystallization of the nano-grained CdS1, leading to larger grain sizes and can lead to phase change of the CdS layer to preferentially wurtzite CdS (Fig. 3e).

After step c) a second deposition d) of a further CdS2 layer 41' is carried out, for example again using chemical bath deposition. The CdS2 layer can grow in the same wurtzite phase as the underlying recrystallized CdS1 layer.

This procedure leads to a double layered CdS layer 4, comprising a treated CdS1 layer 41 with large grains and an as deposited CdS2 layer 41' with nano grains. The size of the nano grained CdS is less than 30 nanometers. After the diffusion treatment the grain sizes of the CdS1 layer are enlarged and can reach grain sizes of greater than 30nm. An example of a resulting grain distribution is shown in Fig. 3b. For example, the annealed CdS1 layer has grain sizes of 100-500 nm, while the second CdS2 layer has nano-crystalline grains with less than 30 nm.

The transparent conductive layer 5 consists of a multilayer of highly resistive transparent oxides and conductive transparent oxides. We prefer a double layer of intrinsic ZnO with a thickness of approximately 200 nm and ZnO:Al with a thickness of approximately 800 nm. This double layer was deposited in another deposition step.

As indicated in figure 3a an optional annealing can be carried out either directly after the deposition of the double window layer 4 or after the subsequent deposition of the transparent contact layer 5 in form of at least one transparent oxide. Preferrably this annealing is carried out at temperatures between 180°C and 300°C

In order to determine, where Cu diffuses, the depth dependant distribution of Cu was measured by secondary ion mass spectroscopy (SIMS) and an example of an overview distribution of the back contact 2 to the transparent contact layer 5 is shown in figure 3c. Compared to Cu free devices, the Cu amount in every layer increases.

Even though interpretation of SIMS measurements are difficult due to the matrix effect, we could determine the concentrations of Cu in the different layers to be around 7*10¹⁸ cm⁻³ in the CdS window layer 4 and around 1*10¹⁷ cm⁻³ in the CdTe absorber layer 3 and around 1*10¹⁹ cm⁻³ close to the back contact interface 23 or in the buffer layer 20 in an excellent device with open circuit voltage >800 mV and FF >70%. As can be seen copper could be detected in every layer 2, 20, 3, 4, whereas the copper concentration in the window layer 4 and at the back contact 2 is significantly higher than in the absorber layer 3.

The two visible copper concentration maximums are lying in the window layer 4 and at the back contact-absorber interface 23 respectively in the buffer layer 20, wherein the metal concentration at the back contact-absorber interface 23 and the window layer 4 is at least ten times higher than in the absorber layer 3.

As visible from the SIMS depth profile depicted in figure 3d, Cu is present in the window layer 4 comprising CdS1 and CdS2. In this magnification of the copper depth distribution of the window layer 4 it can be seen that the copper in the large grained CdS1 is higher than in the small grained CdS2.

In one embodiment, only one obvious maximum in the depth dependant metal component distribution is observed and this maximum is located in the window layer 4. Using a diffusion treatment with temperatures at around 200°C, a photovoltaic device 0 showing only the one maximum is achievable. The resulting metal component concentration in the window layer 4 can be at least ten times higher than in the absorber layer 3.

As can be seen in the XRD pattern of figure 3e, a CdS layer 41 as deposited CdS grows in a phase which can correspond to hexagonal CdS 002 or zincblende CdS 111. An optimized double-CdS layer 41, 41' can show an XRD pattern corresponding to hexagonal CdS (100 & 101).

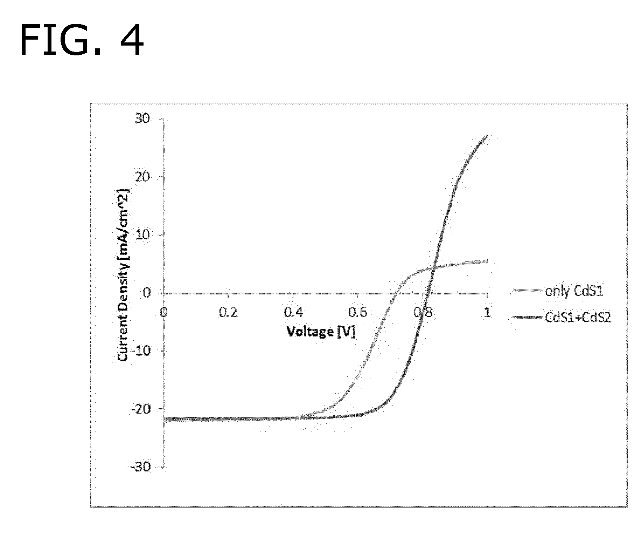

The optimized doubled CdS layer 41, 41' also has a beneficial influence on the photovoltaic device 0 performance. It increases open circuit voltage and fill factor and it reduces rollover in the first quadrant (Fig. 4). Prior art CdTe solar cells in substrate configuration had lower fill factor, more pronounced roll-over and mostly lower V_{oc} than the devices disclosed in this invention. With the process disclosed in some of the embodiments of this invention we achieved >70% fill factor, which was not achieved with previously published processes.

With our new approach a step-like increase in efficiency to more than 13% efficiency was achieved and it still has good potential for further improvement. Furthermore, the newly developed process shows much better reproducibility. Further reduction in cost and increase in throughput can be expected from the use of roll-to-roll production using the disclosed method. Therefore, we see better potential of the invention for flexible foils and low cost metal (e.g. aluminum or mild steel) substrates.

### LIST OF REFERENCE NUMERALS

- 0: photovoltaic device (in substrate configuration)
- 1: substrate
- 2: back contact 23 back contact-absorber interface
- 3: absorber layer/ p-type semiconducting layer 34 pn-junction /absorber-window junction
- 4: window layer 40 metal component 41 n-type semiconducting material
- 5: transparent contact layer (TCO layer)
a) first treatment
b) deposition of n-type semiconducting material
c) second treatment
d) second deposition of n-type semiconducting material
   CdS1 large grained CdS /41'
   CdS2 nano-grained CdS/41

## Claims

1. Method for production of a photovoltaic device (0) in substrate configuration, comprising a p-semiconducting absorber layer (3) which is deposited on a back contact (2) coated substrate (1) and a window layer (4),
**characterized by the steps of**
- a first treatment (a) of the absorber layer (3) in the form of an annealing in the presence of chlorine containing species at temperatures between 350°C and 500°C for time periods of minutes up to hours leading to recrystallization and grain growth of the absorber layer (3),
- a deposition of the window layer (4) on the pretreated absorber layer (3), comprising n-type semiconducting material (41) and a metal component (40) with equivalent metal component amount to a layer thickness of less than 0.5 nm, wherein the n-type semiconducting material (41) and the metal component (40) are deposited either simultaneous or timely staggered in different chronological order,
followed by
- a diffusion treatment, comprising
either an annealing step at temperatures of at least 180°C or a second treatment (c) for time periods of minutes up to hours, so that the metal component atoms can diffuse into both semiconducting layers (3, 4) and the back contact (2), before
- a transparent contact layer (5) is deposited onto the window layer (4).

2. Method according to claim 1, **wherein**
in the deposition step (b')
the amount of the metal component (40) is directly deposited onto the pretreated surface of the p-type semiconducting absorber layer (3),
a subsequent deposition of an amount of n-type semiconducting material (41) onto the annealed and covered surface of the p-type semiconducting absorber layer (3) is carried out,
before the diffusion treatment is carried out.

3. Method according to claim 2, **wherein**
after deposition of the metal component (40) an annealing step at temperatures of at least 180°C is carried out before deposition of the n-type semiconducting material (41).

4. Method according to claim 1, **wherein** the deposition (b") of the window layer (4) is executed after the first treatment (a) by a first deposition of the n-type semiconducting material (41) directly onto the pretreated surface of the p-type semiconducting absorber layer (3)
followed by a subsequent deposition of the metal component (40).

5. Method according to one of the preceding claims, **wherein** after the first treatment (a) and deposition of the window layer (4) comprising the n-type semiconducting material (41) and the metal component (40) according to step b), b') or b") a diffusion treatment in form of a second treatment (c) of this topmost window layer (4) is executed, leading to recrystallisation and grain growth of the n-type semiconducting material (41) and diffusion of metal atoms of the metal component (40) into the existing layer.

6. Method according to claim 5, **wherein** after the second treatment (c) a subsequent deposition of an additional amount of n-type semiconducting material (41') and the subsequent deposition of the transparent contact layer (5) is following.

7. Method according to claim 6, **wherein** after deposition of an additional amount of n-type semiconducting material (41') an optional annealing is conducted, before the transparent contact layer (5) in form of at least one transparent oxide is deposited after the window layer (4), comprising the metal component (40) and the n-type semiconducting material (41, 41').

8. Method according to claim 6, **wherein** after the transparent contact layer (5) in form of at least one transparent oxide is deposited after the window layer (4), comprising the metal component (40) and the n-type semiconducting material (41, 41') an optional annealing is conducted.

9. Method according to one of the preceding claims, **wherein** the p-type semiconducting absorber layer (3) is made of CdTe or of a mixture comprising CdTe and
the n-type semiconducting material of the window layer (4) is CdS or a mixture comprising CdS.

10. Method according to claim 9, **wherein** the amount of CdS in the window layer (4) is deposited according to steps (b, b', b", d) using nano crystals of CdS with sizes less than 30 Nanometer.

11. Method according to one of the preceding claims, **wherein** the metal component (40) comprises Cu, Au, Ag or mixtures thereof.

12. Method according to claim 9, **wherein**
the window layer (4) comprises a second CdS layer (41') with nano grained structure, achieved by deposition of nano-grained CdS with nano crystal sizes of less than 30 nm on the first CdS layer or Cu layer.

13. Multi layer thin film solar cell (0) with
a p-type semiconducting absorber layer (3) and a n-type semiconducting window layer (4) grown on a back contact (2) and a substrate (1) in substrate configuration,
**characterized in that**
the depth dependant distribution of metal atoms of an introduced defined metal component (40) shows a non-zero metal atom concentration in the back contact (2), absorber layer (3) and window layer (4), where
the metal atom concentration in the n-type semiconducting window layer (4) is higher than in more than 90% of the absorber layer (3).

14. Multi layer thin film solar cell (0) according to claim 13,
**wherein** the concentration of the metal atoms has a maximum located in the n-type semiconducting window layer (4) and another maximum in the interface (23) between absorber layer (3) and the back contact (2).

15. Multi layer thin film solar cell (0) according to claim 13 or 14, **wherein** the concentration of the metal atoms in the n-type semiconducting window layer (4) is at least one order of magnitude higher than the concentration of metal atoms in most parts of the absorber layer (3).

16. Multi layer thin film solar cell (0) according to one of the claims 13 to 15, **wherein**
the window layer (4) comprises one CdS layer (CdS1, 41) with large grain structure with grain sizes of more than 30 nanometers and a second CdS layer (CdS2, 41') with nano grained structure with grain sizes below 30 nanometers.

17. Multi layer thin film solar cell (0) according to claim 16,
**wherein** the metal component concentration in the CdS layer (CdS1, 41) with large grain sizes is higher than in the second CdS layer (CdS2, 41') showing a fill factor above 70%.
